# EUROPÄISCHE PATENTSCHRIFT

(11) **EP 1 723 581 B1**
(45) Veröffentlichungstag und Bekanntmachung des Hinweises auf die Patenterteilung: **03.03.2010**
(21) Anmeldenummer: 05742940.9
(22) Anmeldetag: 11.03.2005
(51) Int. Cl.: G06K 19/077, G06K 19/02

(54) **FLACHER TRANSPONDER UND VERFAHREN ZU SEINER HERSTELLUNG**
FLAT TRANSPONDER AND METHOD FOR THE PRODUCTION THEREOF
TRANSPONDEUR PLAT ET SON PROCEDE DE PRODUCTION

(30) Priorität: 12.03.2004 DE 20040037 U
(43) Veröffentlichungstag der Anmeldung: 22.11.2006
(73) Patentinhaber: HID Global GmbH, 65396 Walluf (DE)
(72) Erfinder: MICHALK, Manfred, 99092 Erfurt (DE)
(74) Vertreter: Grosfillier, Philippe
(86) Internationale Anmeldenummer: PCT/DE2005/000452
(87) Internationale Veröffentlichungsnummer: WO 2005/088529

(56) Entgegenhaltungen:
- EP-A- 1 130 542
- US-A1- 2003 132 302
- US-A1- 2003 197 064

## Beschreibung

Die Erfindung betrifft einen flachen Transponder mit einer in einer Schicht oder in einem Schichtverbund angeordneten elektronischen Schaltung, die mindestens einen Chip und Leiterbahnen oder Leiterdrähte enthält, sowie ein Verfahren zu dessen Herstellung.

Der erfindungsgemäße Transponder ist für die Befestigung durch Kleben sowohl an starren als auch an flexiblen Elementen aus Pappe, Papier, Stoff oder Kunststoff geeignet. Bevorzugtes Anwendungsgebiet ist das Anbringen eines kontaktlosen Transponders in einem Passcover.

Sehr flache Transponder werden darüber hinaus für vielfältige Anwendungszwecke in Form von kontaktbehafteten, kontaktlosen oder hybriden Ausführungen verwendet. Sie weisen mindestens ein Chip, welches häufig in einem Modul angeordnet ist, sowie Leiterbahnen oder Leiterdrähte und gegebenenfalls weitere elektronische Bauelemente auf. Kontaktlose oder hybride Ausführungen benötigen eine Antenne.

Es ist bekannt, dass diese Anordnungen in Papierabschnitte eingeklebt sowie in Kunststoffe eingegossen oder einlaminiert werden, um die Lage der Schaltung zu sichern und Beschädigungen zu vermeiden.

EP 11 30 542 offenbart einen derartigen Transponder.

Der für diese Anordnungen erforderliche Schutz soll sowohl die Lagesicherung ihrer Bauelemente als auch eine bestimmte Steifigkeit gewährleisten, um die Transponder automatisiert verarbeiten und prüfen zu können.
Für bestimmte Anwendungen dieser Schaltungen ist es erforderlich, dass sie sowohl einen sicheren mechanischen und elektrischen Schutz der Bauelemente als auch eine hohe Biegsamkeit ermöglichen. Dabei ist es häufig wünschenswert, die Lage des Moduls in der Schaltung nicht zu offenbaren.

Eine weitere Anforderung besteht darin, dass sich die Anordnung wie Pappe oder Papier mit weiteren Deck- oder Schutzschichten mittels wasserbasierender Kleber verleimen lässt.

Bekannt sind Lösungen, welche die auf die Schaltung aufgebrachten Schutzschichten extrem dünn oder extrem weich gestalten, indem diese Schutzschichten aus sehr weichem Kunststoff, zum Beispiel aus synthetischem Papier sowie aus gewebtem oder ungewebtem Stoff natürlicher oder künstlicher Fasern bestehen.

Bei der Verwendung synthetischer Papiere ist nachteilig, dass diese eine hohe Dickentoleranz aufweisen und nicht mit wasserbasierenden Klebern verklebbar sind. Schutzschichten aus Stoff ermöglichen es nicht, Schaltungen so zu schützen, dass maßlich exakte Bedingungen für die Schaltung gewährleistet werden. Weiterhin ist die Lage von Modul und Chip und/oder der elektronischen Bauelemente ertastbar bzw. im Relief sichtbar. Nachteilig ist ferner, dass Stoff zwar gut verklebbar ist, sich jedoch durch die Kleberaufnahme versteift.

Der Erfindung liegt die Aufgabe zugrunde, einen Transponder der eingangs genannten Art und ein Verfahren zu seiner Herstellung anzugeben, der biegeflexibel ist, eine möglichst einheitliche Dicke aufweist und mittels wasserbasierter Kleber mit weiteren Elementen verklebbar ist, wobei dessen elektronische Bauelemente weitgehend vor Beschädigungen durch Knicken und vor Ertasten geschützt sind.

Erfindungsgemäß wird die Aufgabe mit einem Transponder, welcher die in Anspruch 1 angegebenen Merkmale aufweist, und mit einem Verfahren, welches die in Anspruch 13 angegebenen Merkmale aufweist, gelöst.

Vorteilhafte Ausgestaltungen sind in den Unteransprüchen angegeben.

Der Transponder enthält eine Schaltung, die in einem elektrisch isolierenden, flexiblen und wasserbeständigen Kunststoffelement angeordnet ist. Auf das Kunststoffelement ist ein- oder beidseitig eine Deckschicht aus Papier oder papierähnlichem Stoff aufgelegt und durch Laminieren befestigt. Unter Papier im Sinne der Erfindung wird ein blattförmiges Material verstanden, welches vorwiegend aus Naturfasern unterschiedlicher Herkunft hergestellt wurde. Auf einer oder auf beiden Deckschichten und gegebenenfalls auf die darüber oder darunter benachbart angeordneten Teilschichten aus Kunststoff werden Einschnitte gekerbt, so dass das an sich steife Laminat mit der im Laminatinneren befindlichen Schaltung bei Biegebelastung schon bei relativ geringen Kräften an den Kerbstellen abknickt. Die Kerben lassen sich durch gezogene oder gestanzte Einschnitte mit Spezialmessern, durch Einschleifen, durch Einsägen, durch Laserschnitt etc. erzeugen.

Eine weitere Möglichkeit die Kerben zu erzeugen besteht darin, die für den Laminiervorgang erforderlichen Laminierwalzen oder Laminierbleche mit erhabenen, messerartigen Kerbstegen zu versehen, sodass bereits mit dem Vorgang des Laminierens die Kerben in das entstehende Laminat eingepresst bzw. eingeschnitten werden. Auch kann mit dem Laminieren ein erstes Kerbmuster und durch nach dem Laminieren erfolgendes zusätzliches Kerben ein zweites Kerbmuster eingekerbt werden.

Die Kerbtiefe und die Kerbschnittdichte können für Bereiche der Laminatfläche verschieden angebracht werden. Um Modul oder Chip im Laminat nicht ertasten zu können und zu verhindern, dass die Leiterdrähte oder Leiterbahnen am Modul- oder Chipanschluss abknicken, ist es zweckmäßig, die Bereiche um das Modul oder Chip herum nicht oder nur gering zu flexibilisieren, um das Ertasten des Moduls oder Chips zusätzlich zu erschweren.

Ferner ist es zweckmäßig, die Kerbschnitte nach bestimmten Mustern zu gestalten, die eine Kennzeichnung ermöglichen und damit ein zusätzliche Sicherheit gegen das einfache Plagiieren des Laminates gewährleisten. Die Muster können spezielle Linienverläufe, konkrete Zeichen, Punktmuster und Ähnliches darstellen. In bestimmten, flächenmäßig beschränkten Bereichen des Laminates ist ein Durchkerben bzw. ein Durchlochen vorteilhaft. Bei Anwendung schleifender Verfahren oder von Laserschnittverfahren zur Herstellung der Kerben ist es möglich, den Querschnitt der Kerbe (Breite und Öffnungswinkel) als Sicherheitsmerkmal und/oder zur Vorgabe eines bestimmten Knickverhaltens mindest in einem Flächenbereich des Laminates gezielt zu gestalten.

Die Laminate weisen eine hohe Ebenheit, eine geringe Dickentoleranz, eine hohe Druckfestigkeit sowie einen optimalen mechanischen Schutz von Modul, Chip, elektronischen Bauelementen und Leiterbahnen bzw. Leiterdrähten auf. Die Laminate sind mit wasserbasierenden Klebern verklebbar.

Die Erfindung wird im Folgenden anhand von Ausführungsbeispielen näher erläutert.

In der zugehörigen Zeichnung zeigen:
- Figur 1: einen kontaktlosen Transponders in der Draufsicht,
- Figur 2: einen kontaktlosen Transponders im Querschnitt,
- Figur 3: eine Draufsicht auf eine Anordnung mit Kerben
- und Figur 4: die Anordnung gemäß der Erfindung mit Kerben im Querschnitt.

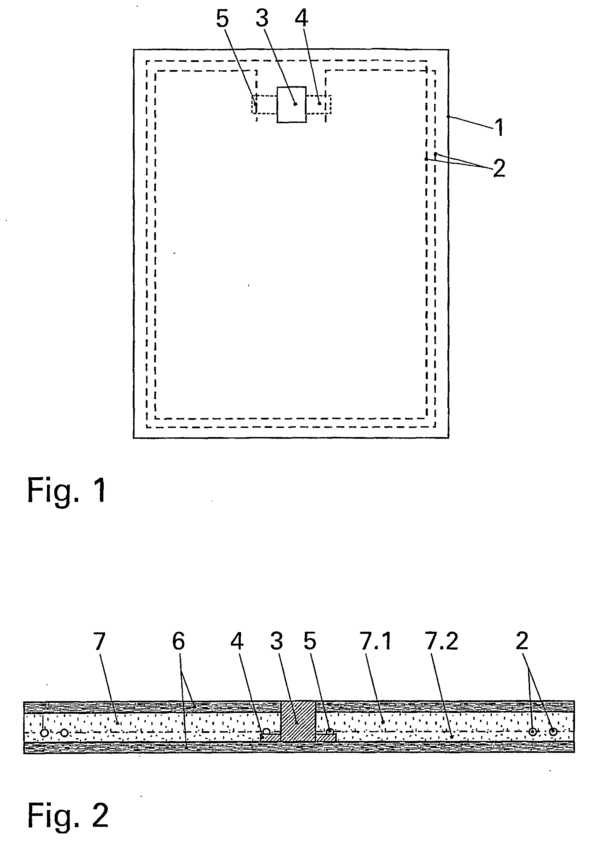

Die in **Figur 1** dargestellte Anordnung zeigt ein Laminat 1 mit einer scheckkartenähnlichen Fläche. Im Laminat 1 ist ein Modul 3 angeordnet, dessen Modulanschlüsse 4 an den Kontaktstellen 5 mit den Enden der Antenne 2 verbunden sind. Die Antenne 2. besteht aus einer Spule mit zwei Windungen aus einem mit einer elektrisch isolierenden Schicht versehenen Kupferdraht, der einen Durchmesser von 50 µm aufweist.

In **Figur 2** ist das Laminat im Querschnitt gezeigt. Die Antenne 2 befindet sich in einem Schaltungsträger 7, der im Beispiel aus einer 200 µm dicken oberen Kunststofffolie 7.1 und einer unteren Kunststofffolie 7.2 besteht. Beide. Folien bestehen aus Polyethylen. Auf der oberen Kunststofffolie 7.1 befinden sich die Antenne 2 und die an den Kontaktstellen 5 mit der Antenne 2 verbundenen Modulanschlüsse 4. Der duroplastische, steife Körper des Moduls 3 ist in einem Loch angeordnet, das durch den Schaltungsträger 7 und die darüber liegende Papierschicht 6 gestanzt ist. Unter der oberen Kunststofffolie 7.1 ist die untere Kunststofffolie 7.2 angebracht, die im Beispiel 100 µm dick ist. Unterhalb der unteren Kunststofffolie 7.2 ist eine zweite Papierschicht 6 angeordnet, so dass die Kunststofffolien 7.1 und 7.2 jeweils mit einer 100 µm dicken Papierschicht 6 bedeckt sind.
Zur Herstellung des Transponders wird die übereinander zusammengelegte Materialschichtung durch heißes Laminieren zu einem kompakten Verbund, dem Laminat 1. Die Leiterdrähte 2 befinden sich dabei zwischen den beiden Kunststofffolien 7.1 und 7.2. Beim Laminiervorgang erweichen die aus Polyethylen bestehenden Kunststofffolien 7.1 und 7.2 vorübergehend. Dabei verbinden sie sich untereinander und mit den Papierschichten 6. Im Beispiel bestehen die Papierschichten 6 aus Papier der steifen Qualität "gestrichenes Papier". Die steifen Papierschichten 6 auf den Außenseiten des Laminates 1 verhindern, dass der aus den Kunststofffolien 7.1 und 7.2 bestehende Polyethylenkern beim Laminieren schrumpft und die Lage der die Antenne 2 bildenden Leiterbahnen bzw. Leiterdrähte 2 signifikant verändert. Durch die nichtschrumpfenden Papierschichten 6, mit denen die Kunststofffolien 7.1 und 7.2 verbacken, wird eine Lagestabilisierung der elektronischen Schaltung und des gesamten Kunststoffkernes erreicht. Diese Lagestabilisierung kann für fast alle zu laminierenden Kunststoffe erreicht werden.

Die aus gestrichenem Papier bestehenden Papierschichten 6 verhindern außerdem, dass die während des Laminierens erweichenden Kunststofffolien 7.1 und 7.2 den Faserverbund der Papierschichten 6 vollständig imprägnieren. Die Imprägnierung ist für diese Anordnung nicht erwünscht, da ein mit Polyethylen vollständig imprägniertes Papier - die vollständige Imprägnierung lässt sich bei dünnen, ungestrichenen Papieren nicht vermeiden - sich mittels wasserbasiertem Kleber nicht oder nur sehr schlecht verkleben lässt. Weiterhin ändert sich je nach Imprägnierungsgrad des ungestrichenen Papiers durch die im Verbund zu laminierenden Kunststofffolien 7.1 und 7.2 die Dicke des Laminates 1 sehr stark, da ein Teil der Kunststoffmasse von den Papierschichten 6 aufgenommen wird. Andererseits erfolgt durch das Laminieren eine Versteifung des Schichtverbundes, was meist nicht erwünscht ist.

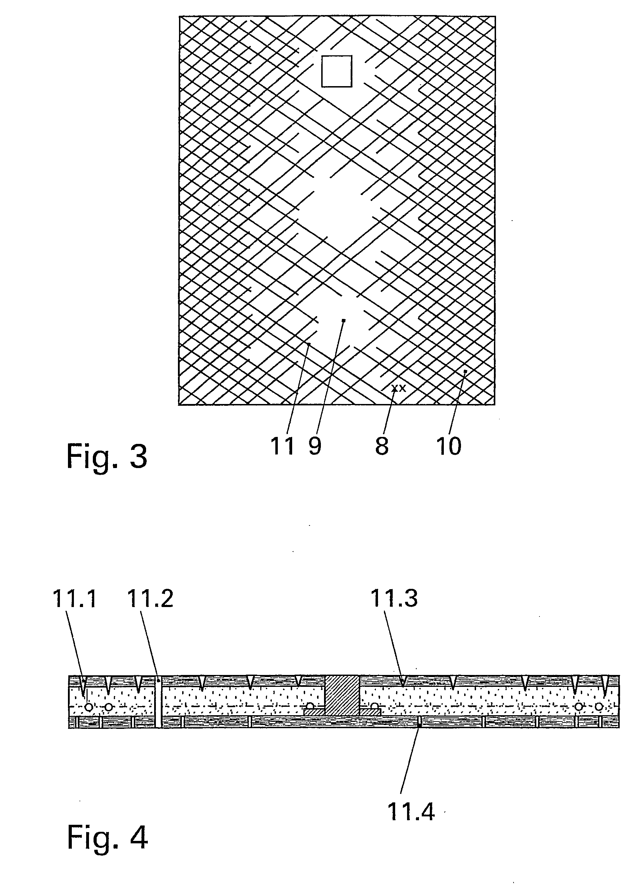

Um trotz Laminierung biegeflexible Laminate 1 zu erhalten, sind die äußeren Papierschichten 6, die wesentlich zur Versteifung beitragen, mit den in **Figur 3** dargestellten Kerben 11 versehen. Die Kerben 11 sind vor allem im linken und rechten Randbereich des Laminates 1 in engen Schnittmustern ausgeführt, um die Flexibilität zu steigern. Die Randbereiche werden damit zu Bereichen geringer Biegesteifigkeit 10.

In der Laminatmitte sind Bereiche hoher Biegesteifigkeit 9 angeordnet. Hierzu weist der Bereich um das Modul 3 keine Kerben 11 auf, um zu verhindern, dass das Laminat 1 direkt am Modul 3 abgeknickt werden kann. Außerdem sind zwei weitere modulähnliche Flächen ohne Kerben 11 ausgeführt, damit ein einfaches Ertasten der genauen Lage des Moduls 3 nicht möglich ist. In der Nähe des unteren Randes des Laminates 1 sind ferner zwei Spezialzeichen 8 eingekerbt, die eine individuelle Kennzeichnung des Laminates 1 und/oder der Charge mit einer Kennzeichnung des Herstellers, des Herstellungsdatums und ähnliches ermöglichen.

Die Kerben 11 sind im dargestellten Beispiel rautenförmig angeordnet, jedoch sind je nach gewünschter Biegeweichheit des Laminates 1, je nach technologischer Möglichkeit und je nach Designwunsch andere Kerbanordnungen möglich. Beispielsweise könne die Kerben 11 in Wellenform, überlappenden Ringformen, beliebigen Vieleckformen usw. angebracht werden. Im Beispiel sind die Kerbschnitte 11 mittels eines CO₂-Lasers nach dem Laminieren erzeugt.

**Figur 4** erläutert Möglichkeiten verschiedenartiger Formen für das Anbringen von Kerben 11 auf dem Laminat 1. Beide Flächenseiten des Laminates 1 sind mit Kerben 11 versehen, wobei jede Flächenseite entsprechend der für die jeweiligen Biegerichtungen geforderten Flexibilitäten unterschiedliche Kerben aufweist. Hierzu können in bestimmten Bereichen tiefe V-förmige Kerben 11.1 und in anderen Bereichen flache V-förmige Kerben 11.3 angebracht werden. Ferner ist es möglich, die Kerben 11 als Durchkerbungen 11.2 oder in Form eines Grabenschnittes 11.4 anzuordnen. In Figur 4 weist die obere Seite des Laminates 1 V-förmige Kerbschnitte auf, die zu den Rändern des Laminates 1 in sich verringernden Abständen und als tiefe V-förmige Kerben angeordnet sind. In der Mitte des Laminates 1 sind flache V-förmige Kerben 11.3 angebracht. Die flachen V-förmigen Kerben 11.3 kerben ausschließlich die Papierschicht 6. Am Rand des Laminates 1 befinden sich tiefe V-förmige Kerben 11.1, die die Papierschicht 6 und etwa 30% der Dicke des Schaltungsträgers 7 kerben. Auf der unteren Flächenseite des Laminates 1 sind Grabenschnitte 11.4 eingebracht, die nur die Papierschicht 6 kerben. Zur besonderen Kennzeichnung ist das Laminat 1 auf der linken Seite mit einer punktförmige Durchkerbung 11.2 versehen.

### BEZUGSZEICHENLISTE

- 1: Laminat
- 2: Antenne
- 3: Modul
- 4: Modulanschluss
- 5: Kontaktstelle
- 6: Papierschicht
- 7: Schaltungsträger
7.1 obere Kunststofffolie
7.2 untere Kunststofffolie
- 8: Spezialzeichen
- 9: Bereich hoher Biegesteifigkeit
- 10: Bereich geringer Biegesteifigkeit
- 11: Kerben
11.1 Tiefer V-förmiger Kerbschnitt
11.2 Durchkerbung
11.3 Flacher V-förmiger Kerbschnitt
11.4 Grabenschnitt

## Patentansprüche

1. Flacher Transponder mit einer in einer Schicht oder in einem Schichtverbund angeordneten elektronischen Schaltung, die mindestens einen Chip und Leiterbahnen oder Leiterdrähte enthält, wobei die Schaltung in oder auf einem Schaltungsträger (7) aus Kunststoff angeordnet ist, auf dessen beiden größeren gegenüberliegenden Außenflächen je eine durch Laminieren aufgebrachte Papierschicht (6) angebracht ist, **dadurch gekennzeichnet, dass** zur Erhöhung der Biegeflexibilität in mindestens einer Papierschicht (6) Kerben (11) eingebracht sind, und dass die Kerben (11) auf verschiedenen Abschnitten der Papierschicht (6) zur Schaffung von Flächenbereichen unterschiedlicher Biegeflexibilität und/oder unterschiedlicher Biegeflexibilitätsrichtungen in unterschiedlichen Abständen und/oder mit unterschiedlicher Tiefe angebracht sind.

2. Transponder nach Anspruch 1, **dadurch gekennzeichnet, dass** die Kerben die Lage des Chips nicht offenbaren.

3. Transponder nach Anspruch 1 oder 2, **dadurch gekennzeichnet, dass** die Kerben (11) in Form von Gräben mit parallelen oder V-förmigen Begrenzungen ausgebildet sind.

4. Transponder nach Anspruch 1 bis 3, **dadurch gekennzeichnet, dass** die Tiefe der Kerben (11) geringer als die Dicke der Papierschicht (6) ist.

5. Transponder nach Anspruch 1 bis 3, **dadurch gekennzeichnet, dass** die Kerben (11) die Papierschicht (6) durchdringen und in die angrenzende Schicht des Schaltungsträgers (7) eindringen.

6. Transponder nach einem der vorhergehenden Ansprüche, **dadurch gekennzeichnet, dass** die Kerben (11) in Form sichtbarer Schnittmuster oder Zeichen angeordnet sind.

7. Transponder nach Anspruch 1, **dadurch gekennzeichnet, dass** die Papierschicht (6) aus gestrichenem Papier besteht.

8. Transponder nach Anspruch 1 oder 7, **dadurch gekennzeichnet, dass** der Schaltungsträger (7) aus einer Schicht besteht, in welcher eine Antenne (2) und ein Modul (3) mit Modulanschlüssen (4) eingebettet sind.

9. Transponder nach Anspruch 1 oder 7, **dadurch gekennzeichnet, dass** der Schaltungsträger (7) aus mindestens zwei Kunststofffolien (7.1, 7.2) besteht, zwischen denen eine Antenne (2) und ein Modul (3) mit Modulanschlüssen (4) angeordnet sind.

10. Transponder nach einem der vorhergehenden Ansprüche, **dadurch gekennzeichnet, dass** der Schaltungsträger (7) aus Polyethylen besteht.

11. Transponder nach einem der Ansprüche 1 bis 10, **dadurch gekennzeichnet, dass** die Schaltung vollständig vom Material des Schaltungsträgers (7) umschlossen ist.

12. Transponder nach einem der Ansprüche 1 bis 10, **dadurch gekennzeichnet, dass** das Modul (3) aus einem steifen Körper besteht, der in einem Durchbruch angeordnet ist, welcher sich im Schaltungsträger (7) und der darüber liegenden Papierschicht (6) befindet.

13. Verfahren zur Herstellung eines Transponders nach einem der Ansprüche 1 bis 12, **dadurch gekennzeichnet, dass** die Schaltung in oder auf einem Schaltungsträger (7) aus Kunststoff angebracht wird und beidseitig des Schaltungsträgers (7) je eine Papierschicht (6) durch heißes Laminieren aufgebracht wird.

14. Verfahren nach Anspruch 13, **dadurch gekennzeichnet, dass** das Laminieren durch Zusammenpressen von Schaltungsträger (7) und Papierschichten (6) zwischen Laminierblechen oder Laminierwalzen erfolgt.

15. Verfahren nach Anspruch 13, **dadurch gekennzeichnet, dass** auf mindestens einer Flächenseite des Laminates (1) Kerben (11) eingebracht werden.

16. Verfahren nach Anspruch 15, **dadurch gekennzeichnet, dass** die Kerben (11) beim Laminieren mittels auf den Laminierblechen oder Laminierwalzen erhaben angebrachten Kerbstegen erzeugt werden, deren Form mit der Form der zu erzeugenden Kerben (11) korrespondiert.

17. Verfahren nach Anspruch 15, **dadurch gekennzeichnet, dass** die Kerben (11) nach dem Laminieren durch Messer- oder Sägeschnitte eingebracht werden.

18. Verfahren nach Anspruch 15, **dadurch gekennzeichnet, dass** die Kerben (11) nach dem Laminieren durch Laserschnitte eingebracht werden

19. Verfahren nach Anspruch 15, **dadurch gekennzeichnet,** die Kerben (11) durch kombiniertes Einbringen mittels Laminierbleche während des Laminierens und nach dem Laminieren durch Messer-, Säge- oder Laserschnitte erzeugt werden.

## Claims

1. Flat transponder having an electronic circuit which is arranged in a layer or in a layer composite and which contains at least one chip and conductor tracks or conductor wires, the circuit being arranged in or on a circuit carrier (7) made of plastic, on whose two larger opposite outer surfaces a paper layer (6) applied by lamination is in each case applied, **characterized in that** notches (11) are introduced into at least one paper layer (6) in order to increase the flexibility and that the notches (11) are applied at different intervals and/or with a different depth on the various sections of the paper layer (6) in order to create surface regions of different flexibility and/or different flexibility directions.

2. Transponder according to Claim 1, **characterized in that** the notches do not disclose the position of the chips.

3. Transponder according to Claims 1 or 2, **characterized in that** the notches (11) are made in the form of trenches having parallel or V-shaped limits.

4. Transponder according to Claims 1 to 3, **characterized in that** the depth of the notches (11) is less than the thickness of the paper layer (6).

5. Transponder according to Claims 1 to 3, **characterized in that** the notches (11) penetrate through the paper layer (6) and penetrate into the adjacent layer of the circuit carrier (7).

6. Transponder according to one of the preceding claims, **characterized in that** the notches (11) are arranged in the form of visible cut patterns or symbols.

7. Transponder according to Claim 1, **characterized in that** the paper layer (6) comprises coated paper.

8. Transponder according to Claim 1 or 7, **characterized in that** the circuit carrier (7) comprises a layer in which an antenna (2) and a module (3) having module connections (4) are embedded.

9. Transponder according to Claim 1 or 7, **characterized in that** the circuit carrier (7) comprises at least two plastic films (7.1, 7.2), between which there are arranged an antenna (2) and a module (3) having module connections (4).

10. Transponder according to one of the preceding claims, **characterized in that** the circuit carrier (7) is polyethylene.

11. Transponder according to one of Claims 1 to 10, **characterized in that** the circuit is enclosed completely by the material of the circuit carrier (7).

12. Transponder according to one of Claims 1 to 10, **characterized in that** the module (3) comprises a rigid body which is arranged in an aperture which is located in the circuit carrier (7) and the paper layer (6) located above the latter.

13. Method for the production of a transponder according to one of Claims 1 to 12, **characterized in that** the circuit is fitted in or on a circuit carrier (7) made of plastic and in each case a paper layer (6) is applied to both sides of the circuit carrier (7) by hot lamination.

14. Method according to Claim 13, **characterized in that** the lamination is carried out by means of pressing of circuit carrier (7) and paper layers (6) together between laminating plates or laminating rolls.

15. Method according to Claim 13, **characterized in that** notches (11) are introduced on at least one surface side of the laminate (1).

16. The method according to Claim 15, **characterized in that** the notches (11) are produced during the lamination by means of notching webs fitted in an elevated manner to the laminating plates or laminating rolls, the form of said notching webs corresponding to the form of the notches (11) to be produced.

17. Method according to Claim 15, **characterized in that** the notches (11) are introduced by means of knife or saw cuts after the lamination.

18. Method according to Claim 15, **characterized in that** the notches (11) are introduced by means of laser cuts after the lamination.

19. Method according to Claim 15, **characterized in that** the notches (11) are produced by combined introduction by means of laminating plates during the lamination and by knife, saw or laser cuts after the lamination.

## Revendications

1. Transpondeur plat présentant un circuit électronique disposé dans une couche ou dans un composite stratifié et contenant au moins une puce ainsi que des pistes conductrices ou des fils conducteurs,
le circuit étant disposé dans ou sur un porte-circuit (7) en matière synthétique qui présente sur ses deux plus grandes surfaces extérieures opposées une couche de papier (6) appliquée par laminage,
**caractérisé en ce que**
pour augmenter la flexibilité en flexion, des entailles (11) sont ménagées dans au moins une couche de papier (6) et **en ce que** les entailles (11) sont ménagées sur différentes parties de la couche de papier (6) en vue de créer des zones de surface qui présentent différentes flexibilités en flexion et/ou différentes orientations de la flexibilité en flexion à différentes distances et/ou de profondeurs différentes.

2. Transpondeur selon la revendication 1, **caractérisé en ce que** les entailles ne révèlent pas la position de la puce.

3. Transpondeur selon les revendications 1 ou 2, **caractérisé en ce que** les entailles (11) sont configurées en forme de rainures dont les frontières sont parallèles ou en forme de V.

4. Transpondeur selon les revendications 1 à 3, **caractérisé en ce que** la profondeur des entailles (11) est inférieure à l'épaisseur de la couche de papier (6).

5. Transpondeur selon les revendications 1 à 3, **caractérisé en ce que** les entailles (11) traversent la couche de papier (6) et pénètrent dans la couche adjacente du porte-circuit (7).

6. Transpondeur selon l'une des revendications précédentes, **caractérisé en ce que** les entailles (11) sont disposées en suivant un motif de découpe visible ou sous la forme de caractères.

7. Transpondeur selon la revendication 1, **caractérisé en ce que** la couche de papier (6) comprend un papier couché.

8. Transpondeur selon les revendications 1 ou 7, **caractérisé en ce que** le porte-circuit (7) comprend une couche dans laquelle sont incorporés une antenne (2) et un module (3) doté de bornes (4) de module.

9. Transpondeur selon les revendications 1 ou 7, **caractérisé en ce que** le porte-circuit (7) comprend au moins deux feuilles (7.1, 7.2) en matière synthétique entre lesquelles sont disposés une antenne (2) et un module (3) doté de bornes (4) de module.

10. Transpondeur selon l'une des revendications précédentes, **caractérisé en ce que** le porte-circuit (7) est en polyéthylène.

11. Transpondeur selon l'une des revendications 1 à 10, **caractérisé en ce que** le circuit est complètement entouré par le matériau du porte-circuit (7).

12. Transpondeur selon l'une des revendications 1 à 10, **caractérisé en ce que** le module (3) comprend un corps rigide disposé dans une perforation située dans le porte-circuit (7) et dans la couche de papier (6) qui le recouvre.

13. Procédé de fabrication d'un transpondeur selon l'une des revendications 1 à 12, **caractérisé en ce que** le circuit est appliqué dans ou sur un porte-circuit (7) en matière synthétique et **en ce qu'**une couche de papier (6) est appliquée par laminage à chaud sur chacun des deux côtés du porte-circuit (7).

14. Procédé selon la revendication 13, **caractérisé en ce que** le laminage s'effectue en comprimant le porte-circuit (7) et les couches de papier (6) entre des plaques de laminage ou des cylindres de laminage.

15. Procédé selon la revendication 13, **caractérisé en ce que** des entailles (11) sont ménagées dans la surface d'au moins un côté du laminé (1).

16. Procédé selon la revendication 15, **caractérisé en ce que** les entailles (11) sont formées lors du laminage au moyen de nervures d'entaillage prévues sur les plaques de laminage ou sur les cylindres de laminage et dont la forme correspond à la forme des entailles (11) à réaliser.

17. Procédé selon la revendication 15, **caractérisé en ce que** les entailles (11) sont ménagées par découpe à la lame ou à la scie après le laminage.

18. Procédé selon la revendication 15, **caractérisé en ce que** les entailles (11) sont réalisées par découpe au laser après le laminage.

19. Procédé selon la revendication 15, **caractérisé en ce que** les entailles (11) sont formées en combinaison avec le laminage par des plaques de laminage et après le laminage par découpe à la lame, à la scie ou au laser.
